# FASCICULE DE BREVET EUROPEEN

(11) **EP 1 114 446 B1**
(45) Date de publication et mention de la délivrance du brevet: **14.04.2010**
(21) Numéro de dépôt: 00948075.7
(22) Date de dépôt: 29.06.2000
(51) Int. Cl.: H01L 21/20

(54) **PROCEDE DE REALISATION D'UNE MEMBRANE MINCE**
HERSTELLUNG EINER DÜNNEN MEMBRAN
METHOD FOR PRODUCING A THIN MEMBRANE

(30) Priorité: 30.06.1999 FR 9908380
(43) Date de publication de la demande: 11.07.2001
(73) Titulaire: S.O.I.TEC Silicon on Insulator Technologies S.A., 38190 Bernin (FR)
(72) Inventeur: ASPAR, Bernard, F-38140 Rives (FR); BRUEL, Michel, F-38113 Veurey (FR); JAUSSAUD, Claude, F-38240 Meylan (FR); LAGAHE, Chrystelle, F-38340 Voreppe (FR)
(74) Mandataire: Audier, Philippe André
(86) Numéro de dépôt international: PCT/FR2000/001898
(87) Numéro de publication internationale: WO 2001/003172

(56) Documents cités:
- EP-A- 0 849 788
- US-A- 5 877 070

## Description

### Domaine technique

La présente invention concerne un procédé de réalisation d'une membrane mince. Cette membrane peut être constituée d'un ou de plusieurs matériaux, en particulier des matériaux monocristallins. Elle peut être autoportée ou fixée sur un substrat support permettant de rigidifier la structure ainsi obtenue.

Ce type de membrane présente de nombreux intérêts. On peut citer à titre d'exemple les substrats compliants pouvant utiliser une membrane ou tout autre application où un film mince est nécessaire (film de silicium sur substrat verre ou plastique). Par substrat compliant, on entend une structure capable d'accepter des contraintes induites par une structure qui y adhère et qui peut être une couche déposée sur une surface de ce substrat par exemple par hétéroépitaxie.

### Etat de la technique antérieure

Le document FR-A-2 681 472 décrit un procédé de fabrication de films minces de matériau semiconducteur. Ce document divulgue que l'implantation d'un gaz rare ou d'hydrogène dans un substrat en matériau semiconducteur est susceptible de créer des microcavités ou des microbulles (encore désignées par le terme "platelets" dans la terminologie anglo-saxonne) à une profondeur voisine de la profondeur moyenne de pénétration des ions implantés. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérant au raidisseur d'une part, le reste du substrat semiconducteur d'autre part. La séparation a lieu à l'endroit où les microcavités ou microbulles sont présentes. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Ce procédé peut également s'appliquer à la fabrication d'un film mince de matériau solide autre qu'un matériau semiconducteur (un matériau conducteur ou diélectrique), cristallin ou non.

Les procédés décrits par les documents FR-A-2 681 472 (correspondant au brevet américain 5 374 564) déjà cité et FR-A-2 767 416 permettent le report d'un film mince de matériau homogène ou constitué de multicouches homogènes ou hétérogènes sur un support mécanique encore appelé raidisseur. Ce report est réalisé de façon avantageuse à l'aide d'un traitement thermique. Cependant, ce traitement thermique peut être associé ou entièrement remplacé par une séparation mécanique, par exemple à l'aide de forces de traction et/ou de cisaillement et/ou de flexion, appliquées de façon séparées ou combinées entre elles. Un tel procédé est décrit dans le document FR-A-2 748 851.

Il a également été démontré que cette technique pouvait être utilisée sans raidisseur lorsque les ions implantés sont localisés à une profondeur suffisante pour induire la fracture sur l'ensemble du substrat sans formation de cloques au niveau de la surface implantée. On pourra se reporter à ce sujet au document FR-A-2 738 671 (correspondant au brevet américain 5 714 395). Dans ce cas, pour obtenir une fracture il est nécessaire que la zone de microcavités soit à une profondeur minimale par rapport à la surface implantée pour que le film mince soit suffisamment rigide. Cette rigidité peut également être obtenue par l'utilisation d'une ou de plusieurs couches déposées sur la couche mince avec fracture.

Les documents cités ci-dessus décrivent des procédés qui permettent d'obtenir une couche mince de matériau. Cette couche peut être homogène, contenir tout ou partie d'un composant microélectronique ou optoélectronique, ou bien encore être hétérogène. Par hétérogène on entend qu'elle peut être constituée de plusieurs éléments empilés les uns sur les autres. Ces empilements de couches sont généralement obtenus par croissance épitaxiale. Avec la croissance épitaxiale se pose alors un problème de compatibilité entre les différentes couches. Ces problèmes de compatibilité sont par exemple des paramètres de maille très différents qui entraînent la présence de dislocations dans au moins une des couches. A partir de ces résultats, il apparaît donc impossible d'obtenir certaines structures.

D'autre part, le document FR-A-2 738 671 déjà cité indique que l'implantation doit être effectuée à une énergie telle que la profondeur de pénétration des ions soit supérieure ou égale à une profondeur minimale pour que le film soit rigide. Il est indiqué que dans le silicium la profondeur de pénétration minimale est de l'ordre de 5 µm voire 4 µm. Ceci correspond à une énergie d'implantation d'environ 500 keV. Dans le cas du carbure de silicium qui est un matériau beaucoup plus rigide que le silicium, l'épaisseur minimale de film mince possible est de l'ordre de 1 µm. Ce procédé permet donc d'obtenir des films ou couches minces qui ont des épaisseurs supérieures à une épaisseur limite procurant à la couche mince une certaine rigidité. Il est indiqué qu'une couche mince rigide est une couche dont les propriétés mécaniques sont suffisantes pour éviter que l'application de la deuxième étape (qui correspond à un traitement thermique et/ou mécanique) ne se traduise par l'apparition de gonflements, de bulles et d'éclatements de bulles et donc pour que l'application de la deuxième étape se traduise par un décollement de la surface. Cependant, par ce procédé, il est impossible, suivant la nature mécanique du film désirée, d'obtenir des films minces autoportées avec des implanteurs standard du commerce, c'est-à-dire avec des implanteurs permettant d'implanter à une énergie maximale de 200 keV. Par exemple, il est impossible d'obtenir un film de silicium de 4 µm d'épaisseur avec une telle énergie.

Un autre problème se pose lorsque l'on désire utiliser un implanteur standard (énergie inférieure à 200 keV) pour reporter un film mince sur un support quelconque, c'est-à-dire un support qui n'offre pas une rigidité suffisante pour obtenir un effet raidisseur. Par exemple, il n'est pas possible de reporter un film de silicium monocristallin sur un support souple tel qu'un support en plastique sans passer par un support intermédiaire, de type poignée, comme cela est divulgué par le document FR-A-2 725 074. Il serait pourtant avantageux de disposer d'un procédé qui permette de s'affranchir de cette poignée et qui permette le report direct du film mince sur son support final.

### Exposé de l'invention

L'invention apporte une solution aux problèmes énoncés ci-dessus. Il est proposé de fixer deux substrats l'un à l'autre par leur face implantée, l'implantation étant réalisée de façon que le phénomène de clivage des substrats puisse avoir lieu au niveau des zones implantées. Il est alors possible d'obtenir une membrane constituée par la réunion de deux couches minces. Cette membrane peut être reportée sur tout type de support (semi-conducteur, métallique, plastique, céramique) sans aucune condition sur les forces d'adhérence (fortes ou faibles) entre la membrane et le support.

L'invention a donc pour objet un procédé de réalisation d'une membrane mince, comprenant les étapes suivantes :
- implantation d'espèces gazeuses au travers d'une première face d'un premier substrat et implantation d'espèces gazeuses au travers d'une première face d'un second substrat, chaque implantation apte à creer dans ces substrats des microcavités délimitant pour chaque substrat une couche mince comprise entre ces microcavités et la première face, les microcavités étant aptes à provoquer, postérieurement à ladite implantation, le détachement de la couche mince du reste de son substrat ;
- assemblage du premier substrat sur le second substrat de façon que leurs premières faces soient en regard ;
- détachement de la première couche mince du reste du premier substrat et détachement de la seconde couche mince du reste du second substrat, les couches minces restant assemblées entre elles pour fournir ladite membrane mince.

On entend par espèces gazeuses des éléments, par exemple d'hydrogène ou de gaz rares, sous leur forme atomique (par exemple H) ou sous leur forme moléculaire (par exemple H₂) ou sous leur forme ionique (par exemple H⁺, H⁺₂, ... ) ou sous leur forme isotopique (par exemple deutérium) ou sous forme isotopique et ionique.

Par ailleurs, on entend par implantation tout type d'introduction des espèces définies précédemment, seul ou en combinaison, tel que le bombardement ionique, la diffusion, etc.

Selon une première variante de mise en oeuvre, les étapes se déroulent dans l'ordre suivant :
- implantation du premier substrat et du second substrat,
- assemblage du premier substrat sur le second substrat selon les faces implantées,
- détachement de chaque couche mince, soit de manière simultanée soit de manière successive.

Selon une deuxième variante de mise en oeuvre, les étapes se déroulent dans l'ordre suivant :
- implantation du premier substrat,
- assemblage de la face implantée du premier substrat sur la première face du second substrat destinée à être implantée par la suite,
- détachement de la première couche mince du reste du premier substrat, laquelle reste assemblée sur le second substrat,
- implantation du second substrat au travers de la première couche mince détachée du reste du premier substrat,
- détachement de la seconde couche mince du reste du second substrat, laquelle reste assemblée à la première couche mince pour fournir ladite membrane mince.

Dans les deux substrats, il peut être prévu une étape préliminaire à l'implantation et à l'assemblage des deux substrats, consistant à réaliser une couche d'inclusions dans le substrat à implanter, à une profondeur correspondant à l'épaisseur désirée pour la couche mince à élaborer dans ce substrat, les inclusions constituant des pièges pour les espèces gazeuses qui seront ensuite implantées, par exemple par implantation ionique ou diffusion. La couche d'inclusions peut être formée par une technique de dépôt de film. Elle peut consister en une génération de colonnes ou une génération de joints de grains.

La profondeur moyenne d'implantation des espèces gazeuses peut être, dans un substrat en matériau monocristallin, déterminée en fonction de la disposition du réseau cristallographique du matériau monocristallin par rapport à la direction d'implantation. Pour une énergie donnée, des profondeurs moyennes de pénétration des espèces gazeuses plus importantes peuvent être obtenues si on utilise la canalisation des ions ou des espèces introduites. Pour cela, il suffit d'implanter parallèlement à une direction ou à un plan cristallographique (cas d'un matériau monocristallin uniquement). De façon opposée, on peut réduire la profondeur d'implantation à une énergie donnée en effectuant une implantation inclinée. Dans ce cas, on oriente l'axe cristallographique du matériau de façon qu'il n'y ait pas de direction préférentielle de pénétration des ions dans le matériau.

Eventuellement, l'implantation est réalisée au travers d'une face du premier substrat et/ou du second substrat à partir de laquelle tout ou partie d'au moins un composant électronique et/ou optoélectronique et/ou optique et/ou un microsystème a été élaboré. L'implantation peut être effective même pour des zones masquées.

Selon un autre mode de réalisation, le détachement de chaque couche mince se faisant de manière successive, on élabore, après qu'un premier détachement de couche mince a été réalisé, tout ou partie d'au moins un composant électronique et/ou optoélectronique et/ou optique et/ou un microsystème sur la couche mince révélée par ce premier détachement. A titre d'exemple, le composant réalisé dans une couche mince est une mémoire DRAM. Si une topologie est présente en surface, cette surface peut être planarisée avant la mise en contact.

L'assemblage du premier substrat sur le second substrat peut se faire par une technique choisie parmi le collage par adhésion moléculaire, le collage au moyen d'une substance adhésive et l'utilisation d'un composé intermédiaire.

Cet assemblage du premier substrat sur le second substrat peut aussi se faire avec interposition d'une couche intermédiaire. La présence d'une couche intermédiaire peut modifier la rigidité apparente de la membrane et modifier les conditions de transfert. En particulier, cela peut modifier les conditions de recuit et/ou les conditions mécaniques de fracture.

Avantageusement, le détachement desdites couches minces se fait par application d'un traitement thermique et/ou par application de forces mécaniques. Dans tous les cas, les conditions de transfert dépendent bien évidemment des conditions d'implantation (dose, énergie, budget thermique fourni à la plaque) et des contraintes imposées à la zone implantée par la structure. Les forces mécaniques peuvent comprendre des forces de traction et/ou de cisaillement et/ou de flexion. Les forces mécaniques peuvent être appliquées perpendiculairement aux plans des couches et/ou parallèlement à celles-ci. Elles peuvent être localisées en un point ou une zone ou être appliquées à différents endroits de façon symétrique ou dissymétrique. L'apport d'énergie thermique peut être réalisé par exemple par l'utilisation d'un faisceau laser. L'apport d'énergie mécanique peut se faire par l'utilisation d'ultrasons.

Si le détachement d'une couche mince implique l'application d'un traitement thermique, celui-ci peut s'effectuer sous pression contrôlée (par exemple une pression de gaz ou une pression mécanique). La réduction de la pression au moment du traitement thermique ou au moment de la séparation peut faciliter celle-ci. Il est ainsi possible d'obtenir des séparations pour des doses de gaz implanté et/ou des traitements thermiques plus faibles. Par traitements thermiques plus faibles on entend des recuits réalisés avec une température plus faible et/ou avec un temps plus faible. Dans le cas où la pression est augmentée, les conditions de fracture au moment où la séparation a lieu sont modifiées et l'on peut retarder la séparation. Ce retard peut présenter un avantage en induisant une rugosité de surface après fracture plus faible mais il peut aussi permettre d'obtenir la fracture dans des conditions où le bullage serait atteint avec un recuit à la pression atmosphérique.

Selon les applications, après le détachement d'avec au moins un substrat, la membrane mince peut être fixée à un support final ou temporaire.

L'invention fournit une structure à membrane mince obtenue selon le procédé ci-dessus. Cette structure peut comprendre un support supportant cette membrane, ce support pouvant être en un matériau choisi parmi les matériaux semi-conducteurs, les matériaux plastiques, les matériaux céramiques et les matériaux transparents.

L'une des couches minces peut être en silicium et l'autre en matériau semi-conducteur III-V, par exemple en GaAs.

La membrane peut comporter également une couche intermédiaire interposée entre les deux couches minces. Par exemple, les deux couches minces sont en Si et la couche intermédiaire est en SiO₂, en Si₃N₄ ou en une combinaison de plusieurs matériaux et/ou multicouches. Selon un autre exemple, les deux couches minces sont en matériau semi-conducteur et la couche intermédiaire est en matériau conducteur comme le palladium.

Selon une autre variante de réalisation, l'une des couches minces est en Si, l'autre couche est en Ge, les couches minces étant dopées pour que la structure constitue une cellule photovoltaïque.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 à 4 illustrent différentes étapes du procédé selon la présente invention pour obtenir une membrane auto-portée,
- la figure 5 représente une première structure comportant un support supportant une membrane mince selon la présente invention,
- la figure 6 représente une deuxième structure comportant un support supportant une membrane mince selon la présente invention.

### Description détaillée de modes de réalisation de l'invention

Les substrats à partir desquels seront constituées les couches minces peuvent être massifs ou comprendre déjà une ou plusieurs couches minces déposées par exemple par épitaxie.

L'implantation d'espèces gazeuses peut être réalisée, pour chaque substrat, à des énergies et à des doses différentes. Elle peut aussi être réalisée à partir d'espèces gazeuses différentes.

La fixation des substrats l'un sur l'autre peut être réalisée par collage par adhésion moléculaire avec éventuellement la présence d'une couche intermédiaire qui peut avoir différentes fonctions. Elle peut être choisie à cause de ses propriétés électroniques et/ou optiques et/ou mécaniques et/ou thermiques. Elle peut être isolante ou conductrice. Ses propriétés mécaniques peuvent être choisies de façon à rigidifier la structure et permettre une diminution de l'épaisseur nécessaire.

La séparation des couches minces d'avec leurs substrats peut être réalisée de façon simultanée ou de façon consécutive. La séparation peut être réalisée au moyen de traitement thermique et/ou au moyen de forces mécaniques appliquées simultanément ou après l'éventuel traitement thermique. Dans le cas où le traitement thermique a pour but d'obtenir la séparation, celui-ci doit être réalisé avec un budget thermique qui est fonction de tous les autres traitements thermiques précédant ce recuit (implantation, collage,...). Dans le cas où la séparation utilise un effort mécanique, le traitement thermique peut être faible voire même nul si la plaque a été suffisamment fragilisée au cours de l'étape d'implantation. La séparation mécanique a lieu, par exemple, à l'aide de forces de traction, de cisaillement, de flexion, appliquées de façon séparées ou en combinaison les unes avec les autres.

Une variante du procédé consiste après séparation totale (c'est-à-dire des deux substrats) ou séparation partielle (c'est-à-dire d'un substrat), en la mise en contact de l'une des couches minces avec un support qui permet de maintenir la membrane. Ce support peut être un support intermédiaire permettant de réaliser des étapes de fabrication de composants ou être le support final. L'utilisation de support intermédiaire peut permettre de choisir la face sur laquelle on veut réaliser ces étapes.

L'invention présente de nombreux avantages qui vont être récapitulés ci-dessous.

Elle procure la possibilité d'obtenir des membranes autoportées par implantation ionique à l'aide d'implanteurs classiques qui fonctionnent avec des énergies d'implantation de l'ordre de 200 keV.

Pour une épaisseur de membrane donnée, lorsque les deux substrats sont implantés avant leur fixation, l'utilisation de deux substrats implantés permet de diminuer de moitié la profondeur d'implantation et donc de diminuer l'énergie nécessaire pour cette implantation. Cette diminution d'énergie modifie la dose limite nécessaire au transfert d'une couche mince. En effet, il a été constaté que la dose limite permettant ce transfert augmente lorsque l'énergie d'implantation augmente. A titre d'exemple, pour le cas d'ions hydrogène et pour une énergie de 90 keV, la dose nécessaire au transfert est de l'ordre de 3,5.10¹⁶ H+/cm² alors que cette dose est de l'ordre de 4,5.10¹⁶ H⁺/cm² à 400 keV (dose donnée à titre indicatif pour un même implanteur donné, c'est-à-dire à conditions de courant d'implantation, de contact thermique, de refroidissement éventuel fixées). En résumé, deux implantations n'entraînent pas forcément une dose double.

Il est possible d'obtenir des membranes fines composées d'au moins deux couches en matériaux différents. Il suffit pour cela de mettre en contact deux types de matériaux implantés, la mise en contact pouvant s'effectuer par différents moyens (collage par adhésion moléculaire, utilisation d'un composé intermédiaire, ou même de colle). Parmi les composés intermédiaires, on peut citer à titre d'exemple des composés métalliques, ou des composés isolants et/ou des composés qui permettent de contrôler les contraintes apparaissant dans la structure suite à l'association de couches de matériaux différents. On peut ainsi, grâce à ce procédé, réaliser différentes structures avec au moins deux couches monocristallines qui peuvent éventuellement être de part et d'autre d'un film isolant ou conducteur.

Il est possible de réaliser la structure choisie grâce au choix des profondeurs d'implantation qui peuvent être différentes dans les deux cas. Cette possibilité autorise l'obtention de membranes dissymétriques. Il faut remarquer que la dose limite nécessaire à la séparation est fonction de l'énergie d'implantation et du matériau.

Etant donné qu'il existe deux zones (une dans chaque substrat) contenant des microcavités conduisant à la séparation par fracture des substrats, il est possible de contrôler une zone de fracture par rapport à l'autre. En effet, si l'implantation des substrats est réalisée dans des conditions différentes pour chaque substrat, on peut obtenir d'abord la séparation d'une couche d'avec son substrat tandis que l'autre couche est encore solidaire de son substrat. On obtient alors une membrane constituée de deux couches minces encore solidaire de l'un des substrats. On peut alors réaliser tout ou partie d'un ou de plusieurs composants sur la face révélée par la séparation. En particulier, des étapes comprenant des traitements thermiques peuvent être réalisées. Ensuite, cette face révélée peut être collée sur un support et la séparation de l'autre couche mince d'avec son substrat peut être obtenue à l'aide de forces mécaniques et/ou d'un traitement thermique.

L'intérêt d'obtenir une membrane très mince est qu'on peut la déposer sur n'importe quel support sans qu'il y ait une forte adhésion entre la membrane et ce support. On peut alors obtenir une membrane auto-portée, ce qui est notamment intéressant pour les applications de substrat compliant ou de report sur substrat à forte variation de coefficient de dilatation thermique.

Les espèces gazeuses peuvent être introduites ou localisées au niveau de la zone choisie pour la fracture par différentes méthodes. On peut citer à titre d'exemple, l'implantation d'ions par bombardement (équivalent à l'immersion plasma) ou des méthodes basées sur la diffusion et le piégeage par des inclusions.

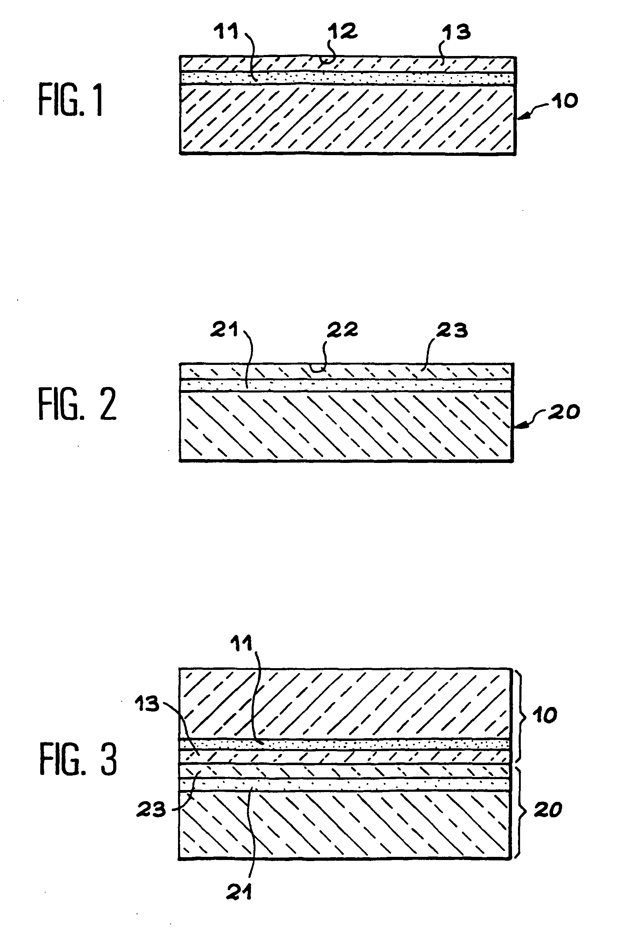

Les figures 1 à 4 sont des vues transversales qui illustrent l'obtention d'une membrane auto-portée, par le procédé de la présente invention, à partir de deux substrats en silicium implantés identiquement.

L'implantation est réalisée par exemple avec des ions hydrogène à une dose de 7.10¹⁶ H⁺/cm² et pour une énergie de 200 keV. Le résultat obtenu est illustré par les figures 1 et 2. La figure 1 montre un premier substrat 10 possédant une zone continue et enterrée de microcavités 11 séparée de la face implantée 12 par la couche mince 13. La figure 2 montre un second substrat 20 possédant une zone continue et enterrée de microcavités 21 séparée de la face implantée 22 par la couche mince 23.

Les substrats 10 et 20 sont ensuite collés l'un à l'autre par les faces implantées 12 et 22 à l'aide d'une technique de collage par adhésion moléculaire. On obtient la structure représentée à la figure 3.

Un recuit de cette structure à une température de l'ordre de 500°C durant 3 0 minutes ou à 400°C pendant 1 heure induit une fracture des substrats dans les zones de microcavités. Ce budget thermique peut être abaissé si les conditions d'implantation sont modifiées, par exemple si la dose est modifiée. Après fracture des substrats, il subsiste une membrane, d'environ 3,5 µm d'épaisseur, constituée de l'association des deux couches minces.

Après retrait d'au moins l'un des deux substrats, la membrane est disponible et peut être recueillie soit manuellement (elle est alors auto-portée), soit en la faisant adhérer sur un support (par exemple une plaque semi-conductrice) ou en la collant sur un film plastique souple.

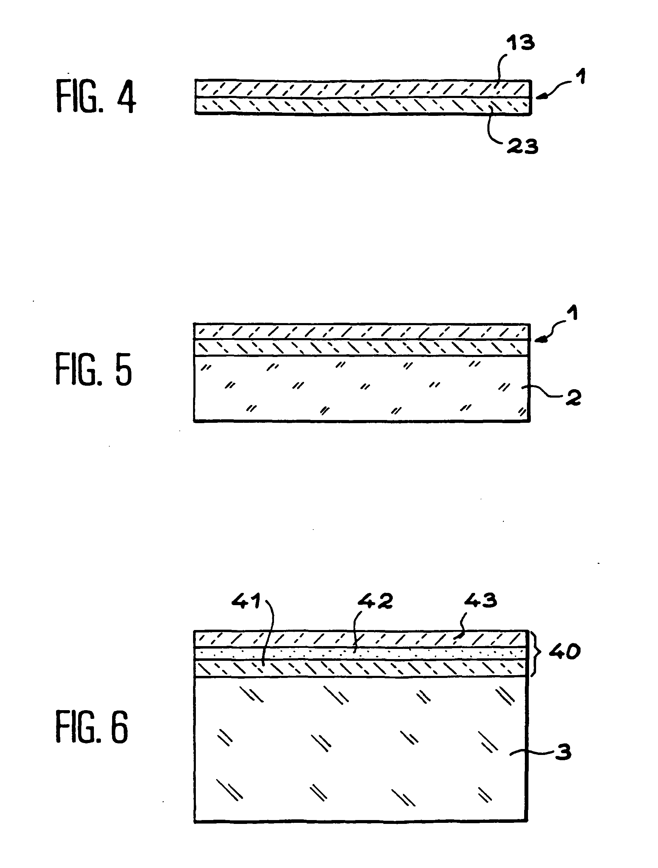

La figure 4 représente une membrane auto-portée 1 constituée des deux couches minces 13 et 23.

La figure 5 représente une structure comprenant un support 2, par exemple en verre, sur lequel la membrane 1 a été collée. Le support 2 peut présenter un coefficient de dilatation thermique différent de celui de la membrane. Il peut être par exemple en silice pure.

Pour certaines applications, il peut être intéressant d'avoir au sein de la membrane une couche d'oxyde. Pour cela, l'un des substrats (ou les deux) sera recouvert d'une couche d'oxyde. On obtient ainsi une membrane formée d'une couche mince de silicium sur une couche d'oxyde qui repose elle-même sur une couche mince de silicium. Cette membrane peut être reportée sur un support quelconque. C'est ce que représente la figure 6 qui montre une structure comprenant un support 3, par exemple en verre, sur lequel une membrane 40 a été collée. Cette membrane 40 comprend une première couche de silicium 41 reposant sur le support 3, une couche d'oxyde 42 et une seconde couche de silicium 43.

Pour d'autres applications, si l'on désire un contact électrique entre les deux couches de la membrane, on peut utiliser une couche intermédiaire métallique, par exemple en palladium.

Le procédé selon la présente invention permet l'obtention d'une membrane comprenant une couche de GaAs et une couche de silicium à partir de substrats correspondants. A titre d'exemple, le substrat de GaAs est implanté avec une dose de 8. 10¹⁶ H⁺/cm² à 200 keV et le substrat de silicium est implanté avec une dose de 10¹⁷ H⁺/cm² à 200 keV. Les deux substrats, après nettoyage, sont collés selon leurs faces implantées par adhésion moléculaire. La structure obtenue est recuite dans un four à 250°C pendant 30 minutes. Ce traitement thermique induit une fracture le long de la zone implantée dans le substrat de GaAs. A ce stade, on a obtenu le transfert d'une couche de GaAs sur un substrat de silicium implanté. Un recuit à 350°C pendant 1 heure de la structure obtenue provoque une fracture le long de la zone implantée dans le substrat de silicium. On obtient une membrane fine composée d'une couche mince de silicium et d'une couche mince de GaAs, qui peut être utilisée comme substrat de croissance pour former une couche d'un nouveau matériau.

Ce procédé permet aussi d'obtenir une membrane uniquement en GaAs à partir de deux substrats en GaAs. Grâce au procédé de l'invention, cette membrane peut être reportée sur n'importe quel type de support, même si celui-ci présente un état de surface incompatible avec le collage par adhésion moléculaire ou si les coefficients de dilatation thermique entre les différents matériaux de la structure sont tels que de fortes contraintes thermiques se manifestent si la structure ainsi formée est recuite. Ce procédé permet également de coller la membrane sur son support à l'aide d'une simple colle ou par soudure ou brasure.

Le procédé selon l'invention permet la réalisation d'une cellule photovoltaïque comportant deux matériaux (Si et Ge) ayant des spectres d'absorption complémentaires afin d'absorber une large part du spectre solaire avec des couches minces. Pour cela, un substrat de silicium est implanté avec une dose de 7.10¹⁶ H⁺/cm² et une énergie de 200 keV en vue d'obtenir une couche mince de 1,8 µm d'épaisseur. Un substrat de germanium est implanté avec une dose de 7.10¹⁶ H⁺/cm² et une énergie de 200 keV en vue d'obtenir une couche mince de 1,6 µm d'épaisseur. Si cela est nécessaire, les substrats de Si et de Ge ont été fortement dopés en surface pour réaliser une jonction tunnel dans la future membrane. Les substrats sont ensuite collés, par adhésion moléculaire, selon leurs faces implantées. Ce collage peut être réalisé par l'intermédiaire d'une couche conductrice et/ou transparente, par exemple un film de Pd ou d'AlTi de 10 nm d'épaisseur.

Par recuit à 500°C pendant 30 minutes, on provoque une fracture dans le substrat de silicium pour obtenir la couche mince correspondante. La partie restante du substrat de silicium est retirée. Une épitaxie peut éventuellement être réalisée sur la couche mince de silicium afin d'améliorer l'absorption photonique par le silicium. Cette épitaxie peut être réalisée en phase liquide ou en phase gazeuse.

On réalise ensuite les éléments de la cellule côté silicium, à une température inférieure à 937°C et la structure est collée, côté silicium, sur un support en verre.

Ensuite, à l'aide de forces mécaniques, par exemple à l'aide de forces de traction, on détache la couche mince de germanium de son substrat pour obtenir une membrane. Un film métallique est alors déposé sur la couche mince de germanium pour former l'électrode face arrière de la cellule qui est encapsulée.

En réalisant des implantations d'hydrogène à plus forte énergie (par exemple à 400 keV), on obtiendrait des couches de silicium et de germanium plus épaisses, donc présentant une plus forte absorption photonique.

On voit par cet exemple l'intérêt de réaliser des membranes composées de deux matériaux avec des épaisseurs importantes et dans tous les cas supérieures aux épaisseurs obtenues avec une énergie d'implantation de 200 keV.

## Revendications

1. Procédé de réalisation d'une membrane mince (1, 40), comprenant les étapes suivantes :
- implantation d'espèces gazeuses au travers d'une première face (12) d'un premier substrat (10) et implantation d'espèces gazeuses au travers d'une première face (22) d'un second substrat (20), chaque implantation apte a créer dans ces substrats des microcavités (11, 21) délimitant pour chaque substrat une couche mince (13, 23) comprise entre ces microcavités et la première face, les microcavités étant aptes à provoquer, postérieurement à ladite implantation, le détachement de la couche mince du reste de son substrat ;
- assemblage du premier substrat (10) sur le second substrat (20) de façon que leurs premières faces (12, 22) soient en regard ;
- détachement de la première couche mince du reste du premier substrat et détachement de la seconde couche mince du reste du second substrat, les couches minces (13, 23) restant assemblées entre elles pour fournir ladite membrane mince (1, 40).

2. Procédé selon la revendication 1, **caractérisé en ce que** les étapes se déroulent dans l'ordre suivant :
- implantations du premier substrat (10) et du second substrat (20),
- assemblage du premier substrat (10) sur le second substrat (20) selon les faces implantées (12, 22),
- détachement de chaque couche mince (13, 23), soit de manière simultanée soit de manière successive.

3. Procédé selon la revendication 1, **caractérisé en ce que** les étapes se déroulent dans l'ordre suivant :
- implantation du premier substrat,
- assemblage de la face implantée du premier substrat sur la première face du second substrat destinée à être implantée par la suite,
- détachement de la première couche mince du reste du premier substrat, laquelle reste assemblée sur le second substrat,
- implantation du second substrat au travers de la première couche mince détachée du reste du premier substrat,
- détachement de la seconde couche mince du reste du second substrat, laquelle reste assemblée à la première couche mince pour fournir ladite membrane mince.

4. Procédé selon l'une quelconque des revendications précédentes, **caractérisé en ce qu'**il est prévu une étape préliminaire à l'implantation, consistant à réaliser une couche d'inclusions dans le substrat à implanter, à une profondeur correspondant à l'épaisseur désirée pour la couche mince à élaborer dans ce substrat, les inclusions constituant des pièges pour les espèces gazeuses qui seront ensuite implantées.

5. Procédé selon l'une quelconque des revendications 1 à 4, **caractérisé en ce que** la profondeur moyenne d'implantation des espèces gazeuses est, dans un substrat en matériau monocristallin, déterminée en fonction de la disposition du réseau cristallographique du matériau monocristallin par rapport à la direction d'implantation.

6. Procédé selon l'une quelconque des revendications 1 à 5, **caractérisé en ce que** l'implantation est réalisée au travers d'une face du premier substrat et/ou du second substrat à partir de laquelle tout ou partie d'au moins un composant électronique et/ou optoélectronique et/ou optique et/ou un microsystème a été élaboré.

7. Procédé selon l'une quelconque des revendications 1 à 5, **caractérisé en ce que**, le détachement de chaque couche mince se faisant de manière successive, on élabore, après qu'un premier détachement de couche mince a été réalisé, tout ou partie d'au moins un composant électronique et/ou optoélectronique et/ou optique et/ou un microsystème sur la couche mince révélée par ce premier détachement.

8. Procédé selon l'une quelconque des revendications 1 à 7, **caractérisé en ce que** l'assemblage du premier substrat (10) sur le second substrat (20) se fait par une technique choisie parmi le collage par adhésion moléculaire, le collage au moyen d'une substance adhésive et l'utilisation d'un composé intermédiaire.

9. Procédé selon l'une quelconque des revendications 1 à 8, **caractérisé en ce que** l'assemblage du premier substrat sur le second substrat se fait avec interposition d'une couche intermédiaire (42).

10. Procédé selon l'une quelconque des revendications 1 à 9, **caractérisé en ce que** le détachement desdites couches minces (13, 23) se fait par application d'un traitement thermique et/ou par application de forces mécaniques.

11. Procédé selon la revendication 10, **caractérisé en ce que** lesdites forces mécaniques comprennent des forces de traction et/ou de cisaillement et/ou de flexion.

12. Procédé selon l'une des revendications 10 ou 11, **caractérisé en ce que** l'étape de détachement comprend l'utilisation d'un faisceau laser pour apporter de l'énergie thermique aux microcavités.

13. Procédé selon l'une des revendications 10 ou 11, **caractérisé en ce que** l'étape de détachement comprend l'utilisation d'ultrasons pour apporter de l'énergie mécanique aux microcavités.

14. Procédé selon la revendication 10, **caractérisé en ce que**, le détachement impliquant l'application d'un traitement thermique, celui-ci s'effectue sous pression contrôlée.

15. Procédé selon l'une quelconque des revendications précédentes, **caractérisé en ce qu'**après le détachement d'avec au moins un substrat, la membrane mince est fixée à un support final ou temporaire.

16. Procédé selon la revendication 15, **caractérisée en ce que** le support est en un matériau choisi parmi les matériaux semi-conducteurs, les matériaux plastiques, les matériaux céramiques et les matériaux transparents.

17. Procédé selon la revendication 16, **caractérisée en ce que** l'une des couches minces est en silicium et l'autre en matériau semi-conducteur III-V.

18. Procédé selon la revendication 16, **caractérisée en ce que** la membrane (40) comporte également une couche intermédiaire (42) interposée entre les deux couches minces (41, 43).

19. Procédé selon la revendication 18, **caractérisée en ce que** les deux couches minces sont en Si et la couche intermédiaire est en SiO₂, en Si₃N₄ ou en une combinaison de plusieurs matériaux et/ou multicouches.

20. Procédé selon la revendication 18, **caractérisée en ce que** les deux couches minces sont en matériau semi-conducteur et la couche intermédiaire est en matériau conducteur.

21. Procédé selon la revendication 20, **caractérisée en ce que** la couche intermédiaire est en palladium.

22. Procédé selon la revendication 15, **caractérisée en ce que** l'une des couches minces est en Si, l'autre couche est en Ge, les couches minces étant dopées pour que la structure constitue une cellule photovoltaïque.

## Claims

1. Method for producing a thin membrane (1, 40), comprising the following steps:
- implantation of gaseous species through a first face (12) of a first substrate (10) and implantation of gaseous species through a first face (22) of a second substrate (20), each implantation in said substrates is able to create microcavities (11, 21) delimiting for each substrate a thin layer (13, 23) lying between these microcavities and the first implanted face, the microcavities being able, after their implantation, to cause detachment of the thin layer from the remaining of its substrate;
- assembly of the first substrate (10) onto the second substrate (20) such that their first faces (12, 22) face one another;
- detachment of the first thin layer from the remaining of the first substrate and detachement of the second thin layer from the remaining of the second substrate, the thin layers (13, 23) remaining assembled together to provide said thin membrane (1, 40).

2. Method according to claim 1, **characterised in that** these steps are conducted in the following order:
- implantations of the first substrate (10) and second substrate (20),
- assembly of the first substrate (10) onto the second substrate (20) via the implanted faces (12, 22),
- detachment of each thin layer (13, 23) either in simultaneous or in successive manner.

3. Method according to claim 1, **characterised in that** the steps are conducted in the following order:
- implantation of the first substrate,
- assembly of the implanted face of the first substrate onto the first face of the second substrate intended to be subsequently implanted,
- detachment of the first thin layer from the remaining of the first substrate, which layer remains assembled to the second substrate,
- implantation of the second substrate through the first thin layer detached from the remaining of the first substrate,
- detachment of the second thin layer from the remaining of the second substrate, which layer remains assembled to the first thin layer to provide said thin membrane.

4. Method according to any of the preceding claims, **characterised in that** a preliminary step is provided prior to implantation, consisting of fabricating a layer of inclusions in the substrate to be implanted, at a depth corresponding to the required thickness of the thin layer to be made in this substrate, the inclusion forming traps for the gas species which will be subsequently implanted.

5. Method according to any of claims 1 to 4, **characterised in that** the average implantation depth of the gas species, in a substrate in monocrystalline material, is determined in relation to the arrangement of the crystallographic network of the monocrystalline material relative to the direction of implantation.

6. Method according to any of claims 1 to 5, **characterised in that** implantation is conducted through one face of the first substrate and/or of the second substrate from which all or part of at least one electronic and/or optoelectronic and/or optic component and/or a microsystem was fabricated.

7. Method according to any of claims 1 to 5, **characterised in that** the detachment of each thin layer being made successively, after a first detachment of thin layer has been made, all or part of at least one electronic and/or optoelectronic and/or optic component and/or a microsystem is made on the thin layer uncovered by this first detachment.

8. Method according to any of claims 1 to 7, **characterised in that** the assembly of the first substrate (10) onto the second substrate (20) is made using a technique chosen from among bonding by molecular adhesion, bonding by means of an adhesive substance or use of an intermediate compound.

9. Method according to any of claims 1 to 8, **characterised in that** the assembly of the first substrate onto the second substrate is made with the insertion of an intermediate layer (42).

10. Method according to any of claims 1 to 9, **characterised in that** the detachment of said thin layers (13, 23) is made by applying heat treatment and/or by applying mechanical forces.

11. Method according to claim 10, **characterised in that** said mechanical forces comprise tensile and/or shearing and/or flexion forces.

12. Method according to either of claims 10 or 11, **characterised in that** the detachment step comprises the use of a laser beam to provide the microcavities with thermal energy.

13. Method according to either of claims 10 or 11, **characterised in that** the detachment step comprises the use of ultrasound to provide the microcavities with mechanical energy.

14. Method according to claim 10, **characterised in that**, the detachment involving the application of heat treatment, the latter is conducted under controlled pressure.

15. Method according to any of the preceding claims, **characterised in that** after detachment from at least one substrate, the thin membrane is fixed to a final or temporary support.

16. Method according to claim 15, **characterised in that** the support is in a material chosen from among semiconductor materials, plastic materials, ceramic materials and transparent materials.

17. Method according to claim 16, **characterised in that** one of the thin layers is in silicon and the other in III-V semiconductor material.

18. Method according to claim 16, **characterised in that** the membrane (40) also comprises an intermediate layer (42) positioned between the two thin layers (41, 43).

19. Method according to claim 18, **characterised in that** the two thin layers are in Si and the intermediate layer is in SiO₂, in Si₃N₄ or in a combination of several materials and/or multilayers.

20. Method according to claim 18, **characterised in that** the two thin layers are in semiconductor material and the intermediate layer is in conductor material.

21. Method according to claim 20, **characterised in that** the intermediate layer is in palladium.

22. Method according to claim 15, **characterised in that** one of the thin layers is in Si, the other layer is in Ge, the thin layers being doped so that the structure forms a photovoltaic cell.

## Patentansprüche

1. Verfahren zur Herstellung einer dünnen Membran, die folgenden Schritte umfassend:
- Implantation gasförmiger Spezies durch eine erste Seite (12) eines ersten Substrats (10) hindurch und Implantation gasförmiger Spezies durch eine erste Seite (22) eines zweiten Substrats (20) hindurch, wobei jede Implantation fähig ist, in diesen Substraten Mikrohohlräume (11, 21) zu erzeugen, die für jedes Substrat eine dünne Schicht (13, 23) abgrenzen, enthalten zwischen diesen Mikrohohlräumen und der ersten Seite der Mikrohohlräume, und die Mikrohohlräume fähig sind, nach der genannten Implantation die dünne Schicht von dem Rest ihres Substrats zu lösen;
- Zusammenbau des ersten Substrats (10) mit dem zweiten Substrat (20), derartig, dass ihre ersten Seiten (12, 22) sich gegenüberstehen;
- Loslösung der ersten dünnen Schicht vom restlichen ersten Substrat und Loslösung der zweiten Schicht vom restlichen zweiten Substrat, wobei die dünnen Schichten (13, 23) miteinander zusammengebaut bleiben, um die genannte dünne Membran (1, 40) zu bilden.

2. Verfahren nach Anspruch 1, **dadurch gekennzeichnet, dass** die Schritte in folgender Reihenfolge ablaufen:
- Implantieren des ersten Substrats (10) und des zweiten Substrats (20),
- Zusammenfügen der implantierten Seiten (12, 22) des ersten Substrats (10) und des zweiten Substrats (20),
- Loslösen jeder dünnen Schicht (13, 23), entweder auf simultane Weise oder auf sukzessive Weise.

3. Verfahren nach Anspruch 1, **dadurch gekennzeichnet, dass** die Schritte in folgender Reihenfolge ablaufes.
- Implantieren des ersten Substrats,
- Zusammenfügen der implantierten Seite des ersten Substrats mit der Seite des zweiten Substrats, die dazu bestimmt ist, später implantiert zu werden,
- Loslösen der ersten dünnen Schicht vom restlichen ersten Substrat, wobei sie mit dem zweiten Substrat zusammengefügt bleibt,
- Implantieren des zweiten Substrats durch die vom restlichen ersten Substrat losgelöste erste dünne Schicht hindurch,
- Loslösen der zweiten dünnen Schicht, die mit der ersten dünnen Schicht zusammengefügt bleibt, vom restlichen zweiten Substrat, um die genannte dünne Membran zu bilden.

4. Verfahren nach einem der vorangehenden Ansprüche, **dadurch gekennzeichnet, dass** ein der Implantation vorausgehender Schritt darin besteht, in dem zu implantierenden Substrat eine Inklusionsschicht zu realisieren, deren Tiefe der erwünschten Dicke der in diesem Substrat herzustellenden dünnen Schicht entspricht, wobei die Inklusionen Fallen für die gasförmigen Spezies bilden, die anschließend implantiert werden.

5. Verfahren nach einem der Ansprüche 1 bis 4, **dadurch gekennzeichnet, dass** die mittlere Implantationstiefe der gasförmigen Spezies in einem Substrat aus monokristallinem Material bestimmt wird in Abhängigkeit von der Anordnung des Kristallgitters des monokristallinen Materials in Bezug auf die fmplantationsrichtung,

6. Verfahren nach einem der Ansprüche 1 bis 5, **dadurch gekennzeichnet, dass** die Implantation durch eine Seite des ersten Substrats und/oder des zweiten Substrats hindurch erfolgt, auf der wenigstens eine elektronische und/oder optoelektronische und/oder optische Baukomponente und/oder ein Mikrosystem ganz oder teilweise realisiert worden ist.

7. Verfahren nach einem der Ansprüche 1 bis 5, **dadurch gekennzeichnet** - wobei das Loslösen jeder dünnen Schicht auf sukzessive Weise erfolgt -, dass man, nachdem eine erste Dünnschicht-Loslösung erfolgt ist, auf der durch diese erste Loslösung offengelegten dünnen Schicht wenigstens eine elektronische und/oder optoelektronische und/oder optische Baukomponente und/oder ein Mikrosystem ganz oder teilweise realisiert.

8. Verfahren nach einem der Ansprüche 1 bis 7, **dadurch gekennzeichnet, dass** bei dem Zusammenbau des ersten Substrats (10) mit dem zweiten Substrat (20) eine zwischen Klebung und Molekularadhäsion ausgewählte Technik angewendet wird, die Klebung mittels einer adhäsiven Substanz und Verwendung einer Intermediärverbindung.

9. Verfahren nach einem der Ansprüche 1 bis 8, **dadurch gekennzeichnet, dass** der Zusammenbau des ersten Substrat mit dem zweiten Substrat mit Einfügung einer Zwischenschicht erfolgt.

10. Verfahren nach einem der Ansprüche 1 bis 9, **dadurch gekennzeichnet, dass** die Loslösung der genannten dünnen Schichten (13, 23) durch Anwendung einer Wärmebehandlung und/oder durch Anwendung von mechanischen Kräften erfolgt.

11. Verfahren nach Anspruch 10, **dadurch gekennzeichnet, dass** die genannten mechanischen Kräfte Zug- und/oder Scher- und/oder Biegekräfte umfassen.

12. Verfahren nach einem der Ansprüche 10 oder 11, **dadurch gekennzeichnet, dass** der Loslösungsschritt die Anwendung eines Lichtstrahls umfasst, um den Mikrohohlräumen thermische Energie zuzuführen.

13. Verfahren nach einem der Ansprüche 10 oder 11, **dadurch gekennzeichnet, dass** der Loslösungsschritt die Anwendung von Ultraschall umfasst, um den Mikrohohlräumen mechanische Energie zuzuführen.

14. Verfahren nach Anspruch 10, **dadurch gekennzeichnet, dass** im Falle der Anwendung einer thermischen Behandlung bei der Loslösung diese unter kontrolliertem Druck erfolgt.

15. Verfahren nach einem der vorhergehenden Ansprüche, **dadurch gekennzeichnet, dass** nach der Loslösung mit wenigstens einem Substrat die dünne Membran an einem finalen oder temporären Träger befestigt wird.

16. Verfahren nach Anspruch 15, **dadurch gekennzeichnet, dass** der Träger aus einem Material ausgewählt unter den Halbleitermaterialien, den Kunststoffmaterialien, den keramischen Materialien und den transparenten Materialien ist.

17. Verfahren nach Anspruch 16, **dadurch gekennzeichnet, dass** eine der dünnen Schichten aus Silicium ist und die andere aus 111-V-Halbleitermaterial ist.

18. Verfahren nach Anspruch 16, **dadurch gekennzeichnet, dass** die Membran (40) auch eine Zwischenschicht (42) umfasst, eingefügt zwischen den beiden dünnen Schichten (41, 43).

19. Verfahren nach Anspruch 18, **dadurch gekennzeichnet, dass** die beiden dünnen Schichten aus Si sind und die Zwischenschicht aus SiO₂, aus Si₃N₄ oder aus einer Kombination mehrerer Materialien und/oder Multischichten ist.

20. Verfahren nach Anspruch 18, **dadurch gekennzeichnet, dass** die beiden dünnen Schichten aus Halbleitermaterial sind und die Zwischenschicht aus Leitermaterial ist.

21. Verfahren nach Anspruch 20, **dadurch gekennzeichnet, dass** die Zwischenschicht aus Palladium ist.

22. Verfahren nach Anspruch 15, **dadurch gekennzeichnet, dass** eine der dünnen Schichten aus Si und die andere Schicht aus Ge ist, wobei die dünnen Schichten so dotiert sind, dass die Struktur eine Fotovoltaikzelle bildet.
